# EUROPEAN PATENT SPECIFICATION

(11) **EP 2 629 331 B1**
(45) Date of publication and mention of the grant of the patent: **14.05.2014**
(21) Application number: 13154912.3
(22) Date of filing: 12.02.2013
(51) Int. Cl.: H01L 27/146

(54) **Method for reducing tilt of optical unit during manufacture of image sensor**
Verfahren zur Reduzierung der Verkippung eines transparenten Fensters während der Herstellung eines Bildsensors
Procédé pour réduire l'inclinaison d'une fenêtre transparente pendant la fabrication d'un capteur d'image

(30) Priority: 16.02.2012 EP 12155846
(43) Date of publication of application: 21.08.2013
(73) Proprietor: Kingpak Technology Inc., Hsin-Chu Hsien (TW)
(72) Inventor: Chuang, Chun-Hua, Hsin-Chu Hsien (TW); Chang, Chien-Wei, Hsin-Chu Hsien (TW); Peng, Chen-Pin, Hsin-Chu Hsien (TW); Hsin, Chung-Hsien, Hsin-Chu Hsien (TW); Huang, Chun-Lung, Hsin-Chu Hsien (TW); Tu, Hsiu-Wen, Hsin-Chu Hsien (TW); Wu, Cheng-Chang, Hsin-Chu Hsien (TW); Yang, Chung-Yu, Hsin-Chu Hsien (TW); Wang, Rong-Chang, Hsin-Chu Hsien (TW); Yang, Jo-Wei, Hsin-Chu Hsien (TW)
(74) Representative: Lang, Christian

(56) References cited:
- US-A1- 2005 161 805
- US-A1- 2006 006 486
- US-B1- 6 428 650

## Description

### Field of the Invention

The present invention relates to a method for reducing the tilt of an optical unit during manufacturing of an image sensor, and more particularly, to a method for reducing the tilt of a transparent plate during manufacturing of an image sensor that can improve the yield rate by carrying out a preheating process to stabilize the process environment.

### Background of the Invention

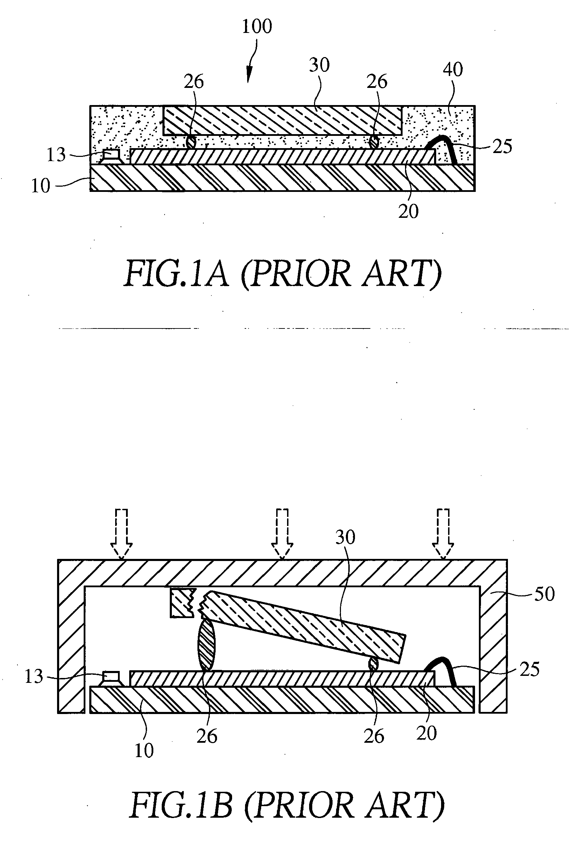

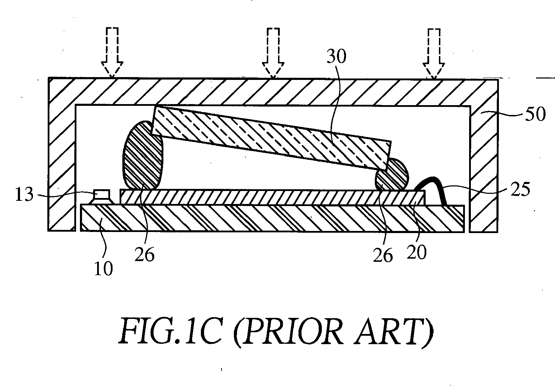

Fig. 1A is a schematic view illustrating a structure of a conventional image sensor. Fig. 1B is a schematic view illustrating tilting and consequent fracture of a transparent plate during a process of manufacturing the conventional image sensor. Fig. 1C is a schematic view illustrating tilting of the transparent plate and consequent overflow of an adhesive during the process of manufacturing the conventional image sensor.

As shown in Fig. 1A, the conventional image sensor 100 substantially includes a circuit substrate 10 (e.g., a printed circuit board; PCB), an image sensor die 20, a transparent plate 30 and an encapsulant 40. The image sensor die 20 is disposed on the circuit substrate 10 and is electrically connected to circuits on the circuit substrate 10 via metal wirings 25 through wire bonding, and the transparent plate 30 is disposed above a photosensitive region (not shown) of the image sensor die 20 by means of an adhesive 26 such as an epoxy resin, and then the metal wirings 25 and side edges of the image sensing die 20 and the transparent plate 30 are encapsulated by the encapsulant 40 through molding.

However, as shown in Fig. 1B, if the adhesive 26 is applied uneven, and then the transparent plate 30 adhered above the photosensitive region (not shown) of the image sensing die 20 is placed in an out-of-level state (e.g., inclined in the lateral direction) during the molding process, the tilt of the transparent plate 30 with respect to the image sensor die 20 or the circuit substrate 10 will become overly large to decrease the sensing quality and this makes it easy to cause fracture of the transparent plate 30 when the mold 50 is pressed downwards during the molding process, which decreases the yield rate of image sensors.

Additionally, as shown in Fig. 1C, the air in a space enclosed by the transparent plate 30, the image sensor die 20 and the adhesive 26 during the molding process tends to expand non-uniformly when heated by a high environmental temperature. This will not only push the transparent plate 30 to cause tilting of the transparent plate 30 but also push the adhesive 26 outwards to cause overflow of the adhesive 26, thus degrading the yield rate of image sensors.

### Summary of the invention

The present invention is a method for reducing the tilt of an optical unit during manufacture of an image sensor. According to the method, a preheating process is carried out to release the air pressure in the vicinity of an image sensor die so that the closed space formed by mounting the optical unit in form of a transparent plate will not expand due to the high temperature of subsequent processes. Additionally, the closed space formed by mounting the transparent plate may be formed with a gap in communication with the outside to lower the pressure inside the closed space, thereby preventing the transparent plate from being out-of-level. Now that the tilt, if any, of the transparent plate is reduced, and the transparent plate is kept from fracture during the transparent plate mounting process, an increased yield rate is achievable.

The present invention provides a method for reducing the tilt of an optical unit in form of an transparent plate during manufacturing of an image sensor, comprising the following steps: providing a semimanufacture of the image sensor, which comprises a circuit substrate and an image sensor die, wherein the circuit substrate has a supporting surface and a bottom surface, a plurality of first conductive contacts are provided on the supporting surface, and the image sensor die comprises: a first surface attached to the supporting surface; a second surface having a photosensitive region; and a plurality of second conductive contacts disposed outside the photosensitive region and electrically connected to the first conductive contacts via metal wirings respectively; carrying out a preheating process by placing the semimanufacture into an environment at a specific temperature; carrying out an adhesive application process by, after the preheating process, applying an adhesive onto the second surface around the photosensitive region without covering the photosensitive region; carrying out a transparent plate closing process by, after the adhesive application process, placing a transparent plate on the adhesive and curing the adhesive to fix the transparent plate onto the second surface and to form an air chamber between the image sensor die and the transparent plate; and carrying out a packaging process by packaging the semimanufacture and the transparent plate with an encapsulant.

Through implementation of the present invention, at least the following effects can be achieved:
1. Environment factors for the semimanufacture during the adhesive application process can be made stable to reduce the tilt of the transparent plate after the transparent plate closing process;
2. The transparent plate is prevented from tilting which may otherwise occur if the air in the air chamber formed by the transparent plate mounting process expands.
3. The adhesive will not overflow after the transparent plate mounting process.
4. A balance between the air pressure in and outside the air chamber formed by the transparent plate mounting process can be reached.
The detailed features and advantages of the present invention will be described in detail with reference to the preferred embodiment so as to enable persons skilled in the art to gain insight into the technical disclosure of the present invention, implement the present invention accordingly, and readily understand the objectives and advantages of the present invention by perusal of the contents disclosed in the specification, the claims, and the accompanying drawings.

### Brief description of the drawings

The invention as well as a preferred mode of use and advantages thereof will be best understood by referring to the following detailed description of an illustrative embodiment in conjunction with the accompanying drawings, wherein:
Fig. 1A is a schematic view illustrating a structure of a conventional image sensor;
Fig. 1B is a schematic view illustrating tilting and consequent fracture of a transparent plate during a process of manufacturing the conventional image sensor;
Fig. 1C is a schematic view illustrating tilting of the transparent plate and consequent overflow of an adhesive during the process of manufacturing the conventional image sensor;
Fig. 2 is a flowchart diagram of a method for reducing the tilt of an optical unit during manufacturing of an image sensor according to an embodiment of the present invention;
Fig. 3 is a schematic view of a semimanufacture of an image sensor according to an embodiment of the present invention;
Fig. 4A is a top view of a semimanufacture of an image sensor obtained after an adhesive application process according to an embodiment of the present invention;
Fig. 4B is a top view of a semimanufacture of an image sensor obtained after an adhesive application process according to another embodiment of the present invention;
Fig. 4C is a top view of a semimanufacture of an image sensor obtained after an adhesive application process according to yet another embodiment of the present invention;
Fig. 4D is a schematic view of a semimanufacture of an image sensor obtained after an adhesive application process according to an embodiment of the present invention;
Fig. 5 is a schematic view of a semimanufacture of an image sensor obtained after an optical unit mounting process according to an embodiment of the present invention;
Fig. 6A is a perspective view of an intermediate layer according to an embodiment of the present invention;
Fig. 6B is an assembled perspective view of an intermediate layer and a transparent plate according to an embodiment of the present invention;
Fig. 6C is a schematic view of a semimanufacture of an image sensor obtained after an optical unit mounting process according to another embodiment of the present invention;
Fig. 6D is a top view of Fig. 6C;
Fig. 7A illustrates the first aspect of an image sensor obtained after a packaging process according to an embodiment of the present invention;
Fig. 7B illustrates the second aspect of an image sensor obtained after a packaging process according to an embodiment of the present invention.
Fig. 8A is a cross-sectional view illustrating a large-scale packaging mold in combination with semimanufactures of image sensors according to an embodiment of the present invention; and
Fig. 8B is a partially enlarged view of Fig. 7A.

### Detailed description of the invention

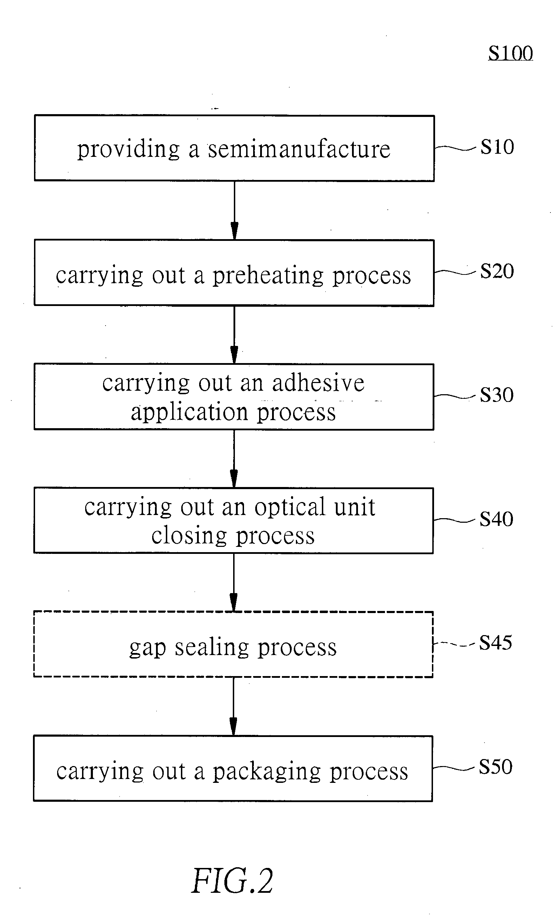

As shown in Fig. 2, this embodiment is a method for reducing the tilt of an optical unit during manufacturing of an image sensor, which comprises the following steps of: providing a semimanfuacture (step S10); carrying out a preheating process (step S20); carrying out an adhesive application process (step S30); carrying out an optical unit closing process (step S40); and carrying out a packaging process (step S50).

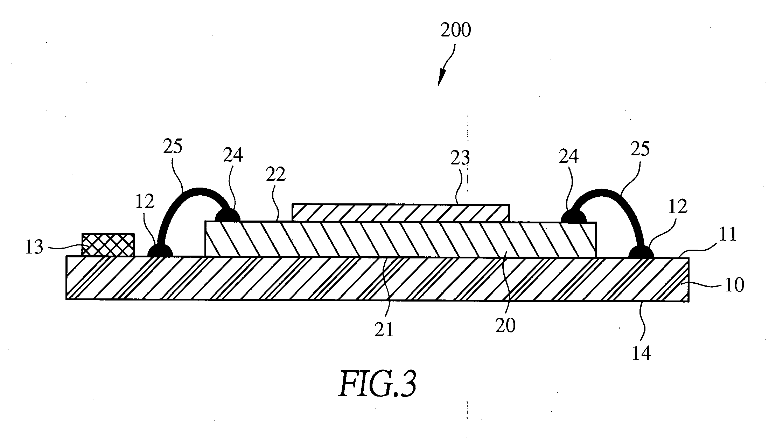

As shown in Fig. 3, a semimanufacture is provided (step S10). The semimanufacture 200 provided in this embodiment is a semimanufacture of an image sensor, which comprises a circuit substrate 10 and an image sensor die 20.

The circuit substrate 10 has a supporting surface 11 and a bottom surface 14. A plurality of first conductive pads 12 is disposed on the supporting surface 11 for electrical connection in the wire bonding process and the plurality of first conductive pads 12 is electrically connected to circuits on the supporting surface 11. Additionally, a drive integrated circuit (IC) and passive elements 13 may also be optionally disposed on the supporting surface 11 and electrically connected to the circuits on the supporting surface 11.

The image sensor die 20 may be a complementary metal oxide semiconductor (CMOS) image sensor die or a charge coupled device (CCE), and it comprises: a first surface 21; a second surface 22; and a plurality of second conductive contacts 24.

The first surface 21 is the lower surface of the image sensor die 20, and is attached to the supporting surface 11 through use of an adhesive so that the image sensor die 20 is attached to the circuit substrate 10. The second surface 22 is the upper surface of the image sensor die 20, and has a photosensitive region 23 for receiving and sensing light rays. The second conductive contacts 24 are disposed outside the photosensitive region 23 and electrically connected to the first conductive contacts 12 on the first surface 21 by metal wirings 25 respectively. Thus, the image sensor die 20 can be electrically connected to the drive 1C and the passive elements 13 through the circuits on the supporting surface 11.

A preheating process is carried out (step S20) by placing the semimanufacture 200 into an environment at a specific temperature. The environment at the specific temperature may be an oven, and the specific temperature may range between 35°C and 45°C. By preheating the semimanufacture 200, the air temperature around the second surface 22 and the supporting surface 11 can be increased to a temperature range which is the same as the environment temperature in the subsequent adhesive application process and the subsequent optical unit closing process so as to release the air pressure in the space around the second surface 22 and the supporting surface 11. This can prevent the air around the second surface 22 and the supporting surface 11 from being influenced by the temperature rise in the subsequent adhesive application process or the subsequent optical unit closing process to cause non-uniform expansion and consequent tilting of the optical unit (not shown). This can also prevent the enclosed space formed in the optical unit closing process from expanding due to the temperature rise to cause unevenness of the optical unit, and prevent occurrence of overflow of the adhesive.

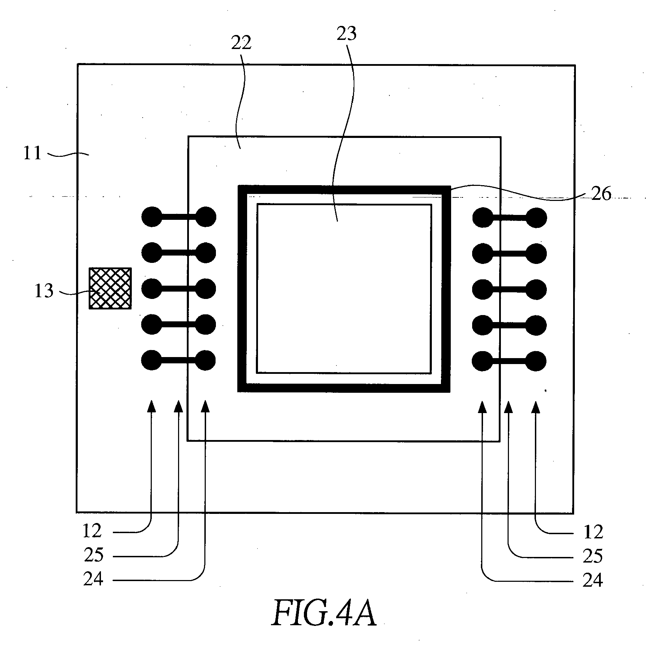

As shown in Fig. 4A, an adhesive application process is carried out (step S30) after the preheating process (step S20) by applying an adhesive 26 onto the second surface 22 around the photosensitive region 23 without covering the photosensitive region 23. During the adhesive application process (step S30), the environment temperature may still be maintained at the specific temperature which is the same as that of the preheating process (e.g., between 35°C and 45°C). The adhesive 26 may be applied in regions between the photosensitive region 23 and the second conductive contacts 24 to form a closed pattern, which looks like a frame-shaped pattern. Thereby, the photosensitive region 23 after being packaged can be accommodated in the space formed by the adhesive 26 and the transparent plate (not shown) to prevent the photosensitive region 23 from being influenced by external factors.

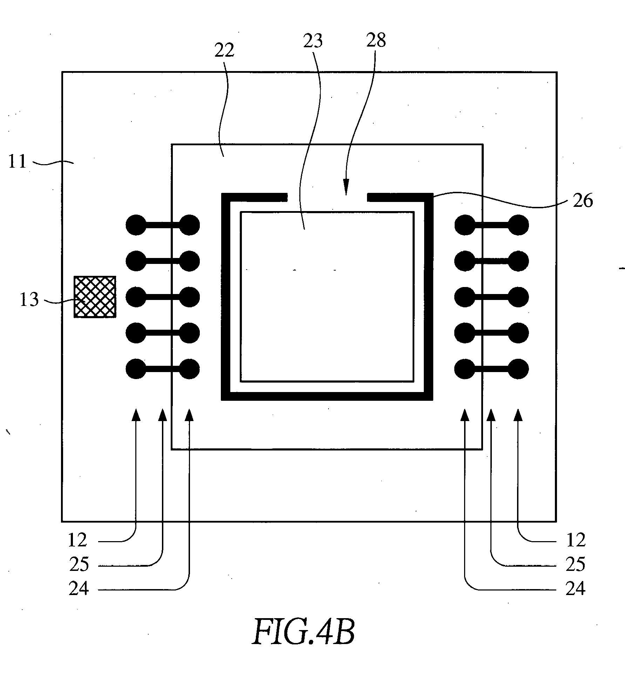

In addition to carrying out step S20 to prevent pressure from building up in the aforesaid closed space due to a subsequent temperature rise, a gap may be formed to bring the closed space into communication with the outside and thereby reduce the pressure in the closed space. In the adhesive application process (step S30), referring to Fig. 4B, the adhesive 26 may be applied to an area between the photosensitive region 23 and the second conductive contacts 24 in such a way that the adhesive 26 not only does not cover the photosensitive region 23, but also forms a generally C-shaped pattern. Thus, the adhesive 26 has a gap 28 at the opening of the generally C-shaped pattern. This allows the air in the space enclosed by the adhesive 26, the optical unit (not shown), and the image sensor die 20 to communicate with the air outside the gap 28, thereby balancing the pressure inside and outside the gap 28.

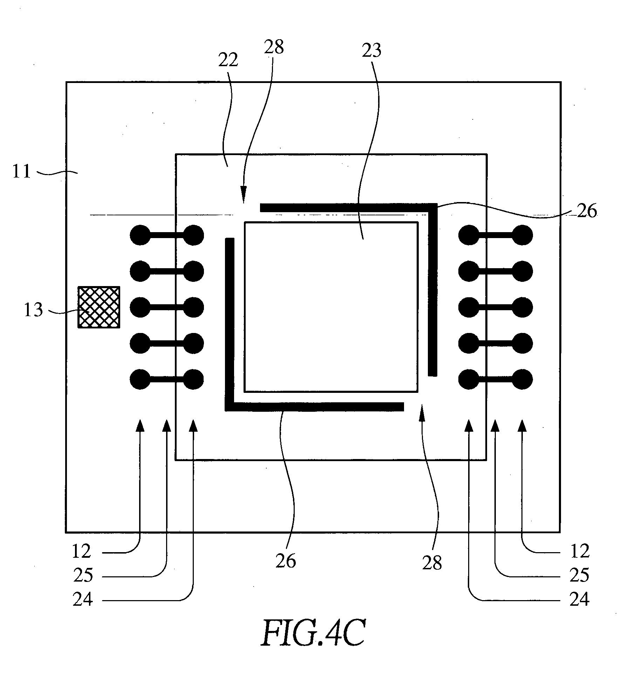

As shown in Fig. 4C, the adhesive application process (step S30) may also be carried out in such a manner that the adhesive 26 is applied to an area between the photosensitive region 23 and the second conductive contacts 24 and forms two L-shaped patterns that face each other. Thus, a hollow square pattern with a gap 28 in each of two opposite corners is formed. The two gaps 28 are located in two opposite right-angled corners of the hollow square pattern respectively such that the air in the space enclosed by the adhesive 26, the optical unit (not shown), and the image sensor die 20 can communicate with the air outside the gaps 28 to achieve a balance between the pressure inside and outside the gaps 28, thereby preventing unevenness of the optical unit and overflow of the adhesive, both of which may otherwise result from a pressure rise in the closed space formed by the optical unit mounting process (step S40).

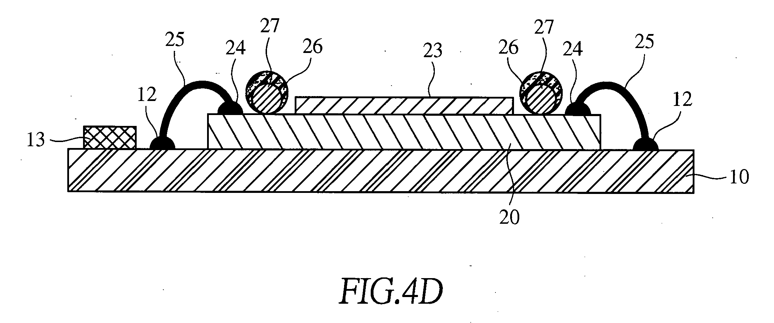

As shown in Fig. 4D, a plurality of ball spacers 27 may be further added into the adhesive 26 to keep a most appropriate distance between the optical unit (e.g., transparent plate 30) and the image sensing die 20 so that the tilt of the optical unit is controlled to be within a reasonable range.

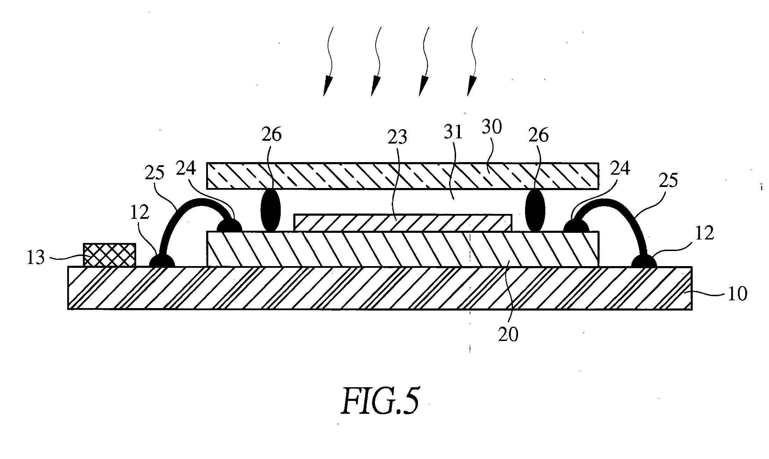

Then as shown in Fig. 5, an optical unit closing process (step S40) is carried out. The optical unit can be a transparent plate 30 made of glass. The optical unit closing process is carried out after the adhesive application process (step S30) by placing the optical unit (e.g., transparent plate 30) on the adhesive 26 and curing the adhesive 26 to fix the optical unit onto the second surface 22 and to form an air chamber 31 between the image sensor die 20 and the optical unit. During the optical unit closing process (step S40), the environment temperature may also be maintained at the specific temperature which is the same as that of the preheating process (e.g., between 35°C and 45°C).

The adhesive 26 may be a photocurable adhesive, and particularly an ultraviolet (UV) curable adhesive; and in the optical unit closing process (step S40), the UV curable adhesive is cured through irradiation of UV light rays.

As shown in Fig. 4D through Fig. 6B, in cases where no ball spacers 27 are added into the adhesive 26, the optical unit may include an intermediate layer 32 in addition to the transparent plate 30 in order to keep the transparent plate 30 properly spaced from the image sensor die 20 and thereby control the tilt of the transparent plate 30 within a reasonable range. The intermediate layer 32 has a fixed height and serves to control the spacing between the transparent plate 30 and the image sensor die 20.

The intermediate layer 32 is a hollow square structure and therefore will not cover the photosensitive region 23 when aligned with and adhesively attached to the adhesive 26 in the optical unit mounting process (step S40). Furthermore, a frame-shaped groove 33 may be formed on the inner side of an upper surface 35 of the intermediate layer 32 so that the transparent plate 30 can be adhesively attached to the frame-shaped groove 33. The intermediate layer 32 may be made of glass, ceramic, a liquid crystal polymer, a molding compound, a siloxane-based polymer, a photosensitive dry film, or a solder mask.

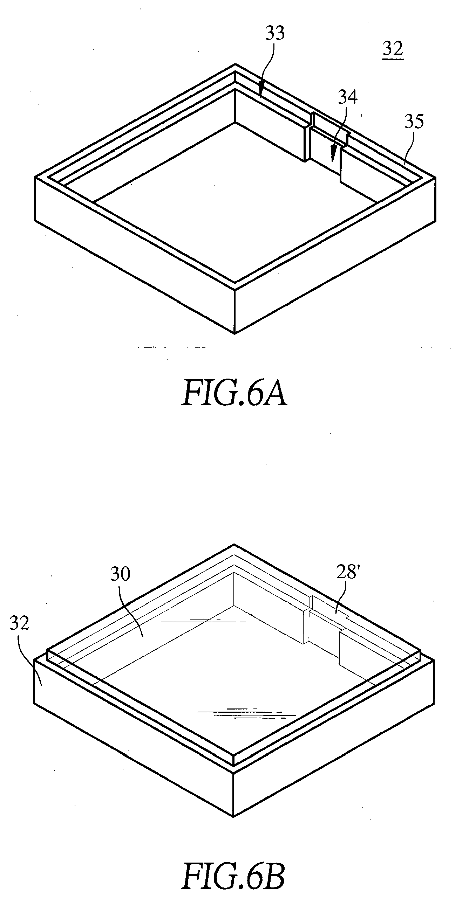

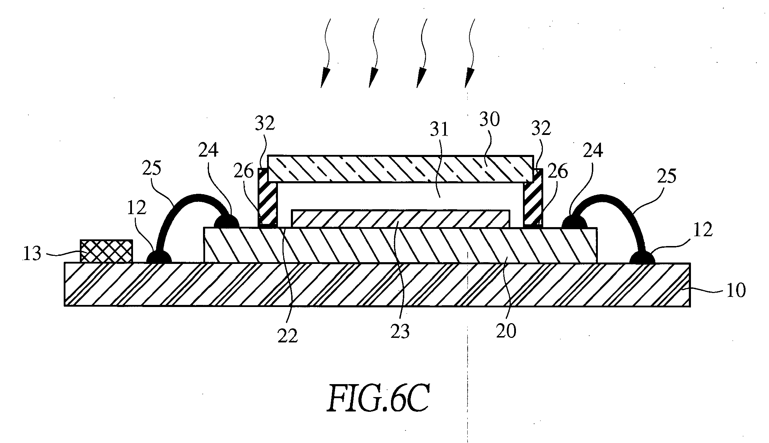

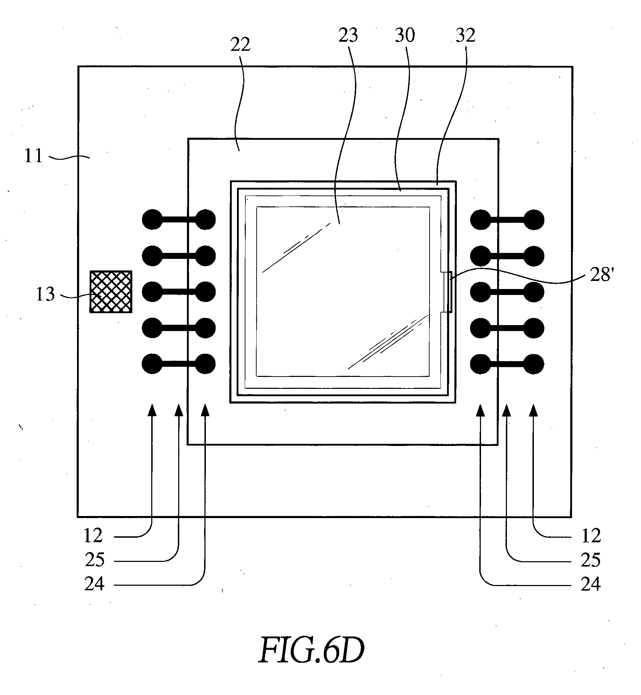

Referring also to Fig. 6C and Fig. 6D, while the foregoing processes are designed to render the pressure in the air chamber 31 as close to the ambient pressure as possible to prevent unevenness of the optical unit, the inner side of the intermediate layer 32 may further have a recess 34 so that, when the transparent plate 30 is attached to the intermediate layer 32 (e.g., adhesively attached to the frame-shaped groove 33) in the optical unit mounting process (step S40), a gap 28' is formed outside the transparent plate 30 to prevent complete air-tightness. The gap 28' enables air circulation into and out of the air chamber 31 and ensures secure adhesion of the optical unit, which secure adhesion is difficult to achieve if the pressure in the air chamber 31 is greater than that outside the air chamber 31.

As shown in FIG. 2, the method S100 for reducing the tilt of an optical unit during manufacture of an image sensor further includes a gap sealing process (step S45). The gap sealing process (step S45) is carried out after the optical unit mounting process (step S40) by sealing the gap(s) 28/28' with a sealant so as to protect the photosensitive region 23 from influences of external factors.

Finally, a packaging process (step S50) is carried out by packaging the semimanufacture and the optical unit with an encapsulant 40 through use of a molding process or a dispensing technology.

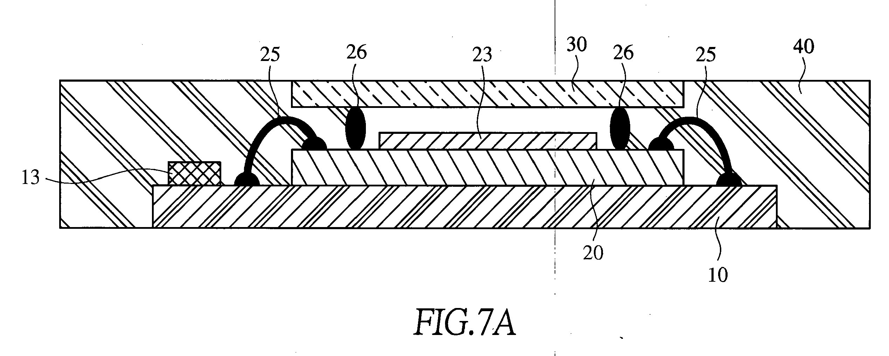

As shown in Fig. 7A, the encapsulant 40 may be applied to cover side edges of the semimanufacture, the adhesive 26, and the optical unit (e.g., transparent plate 30). More specifically, a space formed by side edges of the optical unit and a bottom surface of the optical unit, side edges of the circuit substrate 10 and a top surface of the circuit substrate 10, and the periphery of the closed pattern region applied with the adhesive 26 may be encapsulated by the encapsulant 40. Thus, by using the encapsulant 40 to cover the side edges of the circuit substrate 10, the side edges of the circuit substrate 10 can be prevented from being damaged due to impacts.

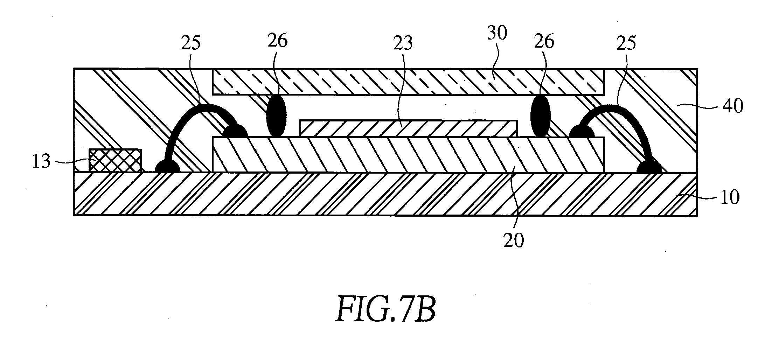

Further, as shown in Fig. 7B, the encapsulant 40 may also be disposed on the circuit substrate 10 and cover the side edges of the image sensor die 20, the adhesive 26, and the optical unit (e.g., transparent plate 30). More specifically, a space formed by side edges of the transparent plate 30 and the bottom surface of the transparent plate 30, the top surface of the circuit substrate 10 (but except for the side edges of the circuit substrate 10) and the periphery of the closed pattern region applied with the adhesive 26 may be encapsulated by the encapsulant 40.

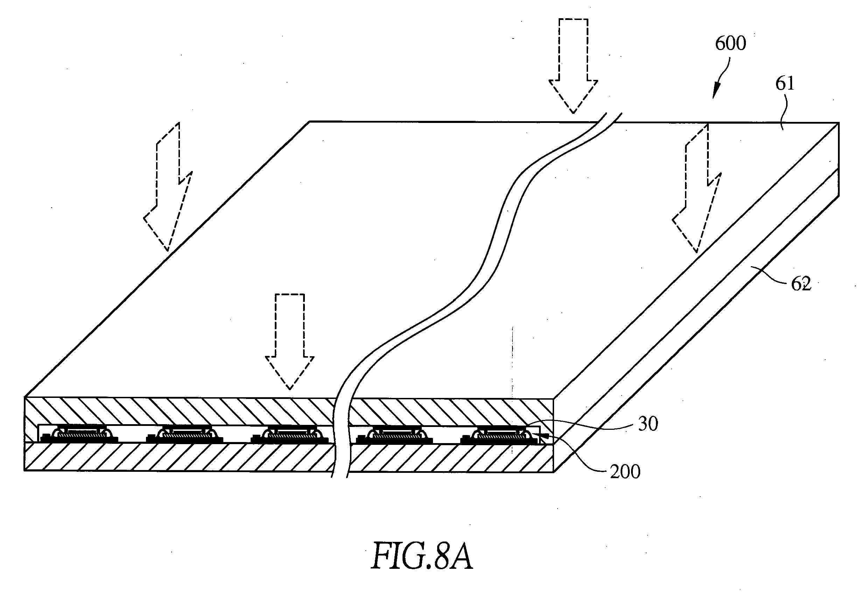

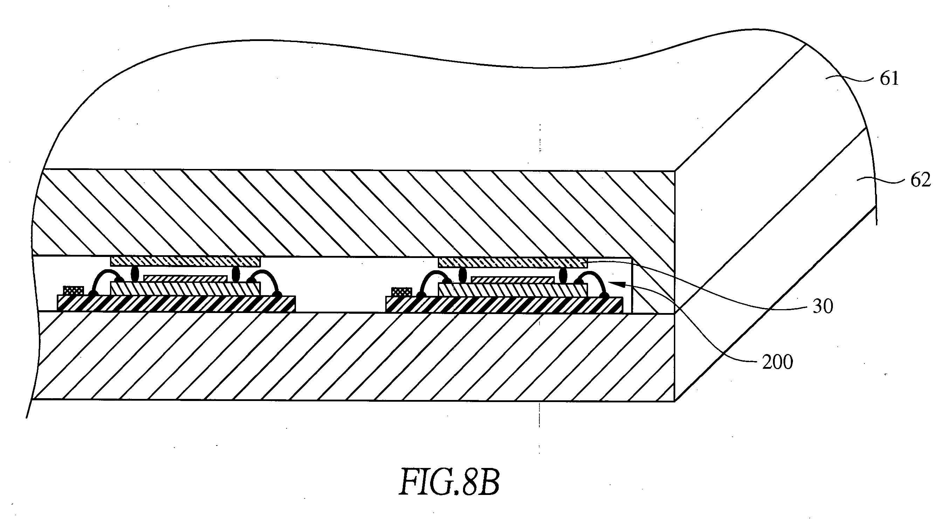

As shown in Fig. 8A and Fig. 8B, in this embodiment, semimanufactures 200 that have been subjected to the optical unit closing process (S40) may also be arranged on a base 62 of a large-scale packaging mold 600, and then a top cover 61 of the large-scale packaging mold 600 is joined with the base 62 to carry out the packaging process (step S50) so as to achieve the purpose of mass production.

## Claims

1. A method for reducing the tilt of a transparent plate during manufacturing of an image sensor, comprising the following steps:
providing a semimanufacture of the image sensor (step S10), which comprises a circuit substrate (10) and an image sensor die (20), wherein the circuit substrate (10) has a supporting surface (11) and a bottom surface (14), a plurality of first conductive contacts (12) are provided on the supporting surface (11), and the image sensor die (20) comprises: a first surface (21) attached to the supporting surface (11); a second surface (22) having a photosensitive region (23); and a plurality of second conductive contacts (24) disposed outside the photosensitive region (23) and electrically connected to the first conductive contacts (12) via metal wirings (25) respectively;
carrying out a preheating process (step S20) by placing the semimanufacture (200) into an environment at a specific temperature;
carrying out an adhesive application process (step S30) by, after the preheating process (step S20), applying an adhesive (26) onto the second surface (22) around the photosensitive region (23) without covering the photosensitive region (23);
carrying out a transparent plate closing process (step S40) by, after the adhesive application process (step S30), placing a transparent plate on the adhesive (26) and curing the adhesive (26) to fix the transparent plate onto the second surface (22) and to form an air chamber (31) between the image sensor die (20) and the transparent plate; and
carrying out a packaging process (step S50) by packaging the semimanufacture (200) and the transparent plate with an encapsulant (40).

2. The method for reducing the tilt of a transparent plate during manufacturing of an image sensor of Claim 1, wherein the image sensor die (20) is a complementary metal oxide semiconductor (CMOS) image sensor die or a charge coupled device (CCD).

3. The method for reducing the tilt of a transparent plate during manufacturing of an image sensor of Claim 1, wherein the specific temperature ranges between 35°C and 45°C.

4. The method for reducing the tilt of a transparent plate during manufacturing of an image sensor of Claim 1, wherein in the adhesive application process (step S30), the adhesive (26) is applied to an area between a photosensitive region (23) and the second conductive contacts (24) and forms a closed pattern.

5. The method for reducing the tilt of a transparent plate during manufacturing of an image sensor of Claim 1, wherein in the adhesive application process (step S30), the adhesive (26) is applied to an area between a photosensitive region (23) and the second conductive contacts (24) and forms a generally C-shaped pattern, the generally C-shaped pattern having a gap (28).

6. The method for reducing the tilt of a transparent plate during manufacturing of an image sensor of Claim 1, wherein in the adhesive application process (step S30), the adhesive (26) is applied to an area between a photosensitive region (23) and the second conductive contacts (24) and forms two L-shaped patterns, the L-shaped patterns facing each other in such a way that a hollow square pattern with two opposite corners each having a gap (28) is formed.

7. The method for reducing the tilt of a transparent plate during manufacturing of an image sensor of Claim 1, wherein a plurality of ball spacers (27) is further added in the adhesive (26).

8. The method for reducing the tilt of a transparent plate during manufacturing of an image sensor of Claim 1, wherein an environment temperature in the adhesive application process (step S30) or in the transparent plate closing process (step S40) ranges between 35°C and 45°C.

9. The method for reducing the tilt of a transparent plate during manufacturing of an image sensor of Claim 1, wherein the transparent plate is made of glass or wherein the adhesive (26) is a photocurable adhesive.

10. The method for reducing the tilt of a transparent plate during manufacturing of an
image sensor of Claim 9, wherein the photocurable adhesive is an ultraviolet (UV) curable adhesive, and in the transparent plate closing process (step S40), the UV curable adhesive is cured through irradiation of UV light rays.

11. The method for reducing the tilt of a transparent plate during manufacturing of an image sensor of Claim 1, wherein the encapsulant (40) is applied to cover side edges of the semimanufacture (200), the adhesive (26) and the transparent plate in the packaging process (step S50) or wherein the encapsulant (40) is disposed on the circuit substrate (10) and covers the side edges of the image sensor die (20), the adhesive (26) and the transparent plate in the packaging process (step S50).

12. The method for reducing the tilt of a transparent plate during manufacturing of an image sensor of one of the preceding claims, wherein the transparent plate comprises an intermediate layer (32) and a transparent plate (30), the intermediate layer (32) having a hollow square structure and a frame-shaped groove (33) formed on an inner side of an upper surface (35) of the intermediate layer (32), the intermediate layer (32) being aligned with and adhesively attached to the adhesive (26) in the transparent plate mounting process (step S40), the transparent plate (30) being adhesively attached to the frame-shaped groove (33).

13. The method for reducing the tilt of a transparent plate during manufacturing of an image sensor of Claim 12, wherein the intermediate layer (32) has a recess (34) such that, once the transparent plate (30) is attached to the intermediate layer (32), a gap (28') is formed outside the transparent plate (30).

14. The method for reducing the tilt of a transparent plate during manufacturing of an image sensor of Claim 12, wherein the intermediate layer (32) is made of glass, ceramic, a liquid crystal polymer, a molding compound, a siloxane-based polymer, a photosensitive dry film, or a solder mask.

15. The method of claim 5, 6, or 13, further comprising a gap sealing step (step S45) in which the gap or the gaps (28/28') are sealed with a sealant after the transparent plate mounting process (step S40).

## Patentansprüche

1. Verfahren zur Reduzierung der Neigung einer transparenten Platte während der Herstellung eines Bildsensors, das die folgenden Schritte umfasst:
Bereitstellen eines halbfertigen Bildsensors (Schritt S10), der ein Schaltkreissubstrat (10) und eine Bildsensormatrize (20) umfasst, wobei das Schaltkreissubstrat (10) eine Stützfläche (11) und eine Bodenfläche (14) aufweist, wobei eine Vielzahl von ersten leitenden Kontakten (12) an der Stützfläche (11) vorgesehen sind, und wobei die Bildsensormatrize (20) umfasst: eine erste Fläche (21), die an den Stützfläche (11) angebracht ist, eine zweite Fläche (22), die einen photosensitiven Bereich (23) aufweist, und eine Vielzahl an zweiten leitenden Kontakten (24), die außerhalb des photosensitiven Bereichs (23) vorgesehen sind und die durch Metallverdrahtungen (25) jeweils entsprechend elektrisch mit den ersten leitenden Kontakten (12) verbunden sind;
Ausführen eines Vorerhitzungsprozesses (Schritt S20), indem der halbfertige Bildsensor (200) in eine Umgebung mit einer spezifischen Temperatur gebracht wird;
Ausführen eines Haftmittelauftragungsprozesses (Schritt S30), indem nach dem Vorerhitzungsprozess (Schritt S20) ein Haftmittel (26) auf der zweiten Fläche (23) um den photosensitive Bereich (23) herum aufgebracht wird, ohne den photosensitiven Bereich (23) zu bedecken,
Ausführen eines Verschlussprozesses einer transparenten Platte (Schritt S40), in dem nach dem Haftmittelaufbringungsprozess (Schritt S30) eine transparente Platte (30) an dem Haftmittel (26) platziert wird und das Haftmittel (26) ausgehärtet wird, um die transparente Platte (30) an der zweiten Fläche (23) zu befestigen und eine Luftkammer (31) zwischen der Bildsensormatrize (20) und der transparenten Platte (30) auszubilden; und
Ausführen eines Packungsprozesses (Schritt S50), in dem der halbfertige Bildsensor (200) und die transparente Platte mit einer Einkapselung (40) verpackt werden.

2. Verfahren zur Reduzierung der Neigung einer transparenten Platte während der Herstellung eines Bildsensors nach Anspruch 1, wobei die Bildsensormatrize (20) eine komplementärere Metall - Oxid - Halbleiter (CMOS) - Bildsensormatrize oder ein ladungsgekoppeltes Bauteil (CCD) ist.

3. Verfahren zur Reduzierung der Neigung einer transparenten Platte während der Herstellung eines Bildsensors nach Anspruch 1, wobei die spezifische Temperatur zwischen 35 °C und 45 °C liegt.

4. Verfahren zur Reduzierung der Neigung einer transparenten Platte während der Herstellung eines Bildsensors nach Anspruch 1, wobei bei dem Haftmittelaufbringungsprozess (Schritt S30) das Haftmittel (26) in einem Bereich zwischen einem photosensitiven Bereich (23) und den zweiten leitenden Kontakten (24) aufgebracht wird und ein geschlossenes Muster ausbildet.

5. Verfahren zur Reduzierung der Neigung einer transparenten Platte während der Herstellung eines Bildsensors nach Anspruch 1, wobei in dem Haftmittelaufbringungsprozess (Schritt S30) das Haftmittel (26) in einem Bereich zwischen einem photosensitiven Bereich (23) und den zweiten leitenden Kontakten (24) aufgebracht wird und ein im Wesentlichen C-förmiges Muster ausbildet, wobei das im Wesentlichen C-förmige Muster eine Lücke (28) aufweist.

6. Verfahren zur Reduzierung der Neigung einer transparenten Platte während der Herstellung eines Bildsensors nach Anspruch 1, wobei in dem Haftmittelaufbringungsprozess (Schritt S30) das Haftmittel (26) in einem Bereich zwischen einem photosensitiven Bereich (23) und den zweiten leitenden Kontakten (24) aufgebracht wird und zwei L-förmige Muster ausbildet, wobei die beiden L-förmigen Muster so aufeinander ausgerichtet sind, dass ein Muster in Art eines hohlen Quadrats ausgebildet wird, wobei zwei gegenüberliegende Ecken jeweils eine Lücke (28) aufweisen.

7. Verfahren zur Reduzierung der Neigung einer transparenten Platte während der Herstellung eines Bildsensors nach Anspruch 1, wobei ferner dem Haftmittel (26) eine Vielzahl von Kugelabstandshaltern (27) zugefügt ist.

8. Verfahren zur Reduzierung der Neigung einer transparenten Platte während der Herstellung eines Bildsensors nach Anspruch 1, wobei eine Umgebungstemperatur in dem Haftmittelaufbringungsprozess (Schritt S30) oder in dem Verschlussprozess einer transparenten Platte (S40) zwischen 35°C und 45°C liegt.

9. Verfahren zur Reduzierung der Neigung einer transparenten Platte während der Herstellung eines Bildsensors nach Anspruch 1, wobei die transparente Platte (30) aus Glas hergestellt ist oder wobei das Haftmittel (26) ein lichthärtbares Haftmittel ist.

10. Verfahren zur Reduzierung der Neigung einer transparenten Platte während der Herstellung eines Bildsensors nach Anspruch 9, wobei das Haftmittel ein Ultraviolett(UV) - härtbares Haftmittel ist und wobei in dem Verschlussprozess einer transparenten Platte (Schritt S40) das UV - härtbare Haftmittel durch Bestrahlung mit UV - Lichtstrahlen ausgehärtet wird.

11. Verfahren zur Reduzierung der Neigung einer transparenten Platte während der Herstellung eines Bildsensors nach Anspruch 1, wobei die Einkapselung (40) angewendet wird, um seitliche Enden des halbfertigen Bildsensors (200), des Haftmittels (26) und der transparenten Platte in dem Verpackungsprozess (Schritt S50) zu bedecken, oder wobei die Einkapselung (40) auf dem Schaltkreissubstrat (10) vorgesehen ist und die seitlichen Enden der Bildsensormatrize (20), des Haftmittels (26) und der transparenten Platte in dem Packungsprozess (Schritt S50) bedeckt.

12. Verfahren zur Reduzierung der Neigung einer transparenten Platte während der Herstellung eines Bildsensors nach einem der vorhergehenden Ansprüche, wobei die transparente Platte eine Zwischenschicht (32) und eine transparente Platte (30) umfasst, wobei die Zwischenschicht (32) eine Struktur in Art eines hohlen Quadrats und eine rahmenförmige Nut (33) aufweist, die an einer Innenseite einer oberen Fläche (35) der Zwischenschicht (32) ausgebildet sind, wobei die Zwischenschicht (32) in dem Verschlussprozess einer transparenten Platte (Schritt S40) mit dem Haftmittel (26) ausgerichtet wird und haftend an diesem angebracht wird, wobei die transparente Platte (30) haftend an der rahmenförmigen Nut (33) angebracht wird.

13. Verfahren zur Reduzierung der Neigung einer transparenten Platte während der Herstellung eines Bildsensors nach Anspruch 12, wobei die Zwischenschicht (32) eine Ausnehmung (34) aufweist, so dass, sobald die transparente Platte (30) an der Zwischenschicht (32) angebracht ist, eine Lücke (28') außerhalb der transparenten Platte (30) ausgebildet ist.

14. Verfahren zur Reduzierung der Neigung einer transparenten Platte während der Herstellung eines Bildsensors nach Anspruch 12, wobei die Zwischenschicht (32) aus Glas, Keramik, einen Flüssigkristallpolymer, einer Spritzgussverbindung, einem siloxanbasiertem Polymer, einem photosensitiven Trockenfilm oder einer Lötmaske hergestellt ist.

15. Verfahren nach Anspruch 5, 6 oder 13, das ferner einen Lückenabdichtschritt (Schritt S45) umfasst, in welchem die Lücke oder die Lücken (28/28') nach dem Verschlussprozess einer transparenten Platte (Schritt S40) mit einem Dichtungsmittel abgedichtet werden.

## Revendications

1. Procédé pour réduire le basculement d'une plaque transparente pendant la fabrication d'un capteur d'image comprenant les étapes suivantes :
fournir un produit semi-fini du capteur d'image (étape S10) qui comprend un substrat de circuit (10) et une puce de capteur d'image (20), le substrat de circuit (10) ayant une surface de support (11) et une surface de fond (14), une pluralité de premiers contacts conducteurs (12) étant prévus sur la surface de support (11) et la puce de capteur d'image (20) comprenant : une première surface (21) fixée à la surface de support (11), une seconde surface (22) ayant une région photosensible (23) et une pluralité de seconds contacts conducteurs (24) disposés à l'extérieur de la région photosensible (23) et reliés électriquement respectivement aux premiers contacts conducteurs (12) par l'intermédiaire de câblages métalliques (25) ;
exécuter un processus de préchauffage (étape S20) en plaçant le produit semi-fini (200) dans un environnement à une température spécifique ;
exécuter un processus d'application d'adhésif (étape S30) après le processus de préchauffage (étape S20) en appliquant un adhésif (26) sur la seconde surface (22) autour de la région photosensible (23) sans couvrir la région photosensible (23) ;
exécuter un processus de fermeture de plaque transparente (étape S40) après le processus d'application d'adhésif (étape S30) en plaçant une plaque transparente sur l'adhésif (26) et en faisant durcir l'adhésif (26) pour fixer la plaque transparente sur la seconde surface (22) et pour former une chambre d'air (31) entre la puce de capteur d'image (20) et la plaque transparente et
exécuter un processus d'emballage (étape S50) en emballant le produit semi-fini (200) et la plaque transparente avec un encapsulant (40).

2. Procédé pour réduire le basculement d'une plaque transparente pendant la fabrication d'un capteur d'image de la revendication 1 dans lequel la puce de capteur d'image (20) est une puce de capteur d'image à semi-conducteur complémentaire à l'oxyde de métal (CMOS) ou un dispositif à couplage de charge (CCD).

3. Procédé pour réduire le basculement d'une plaque transparente pendant la fabrication d'un capteur d'image de la revendication 1 dans lequel la température spécifique est de l'ordre de 35°C à 45°C.

4. Procédé pour réduire le basculement d'une plaque transparente pendant la fabrication d'un capteur d'image de la revendication 1 dans lequel, dans le processus d'application d'adhésif (étape S30), l'adhésif (26) est appliqué à une zone entre une région photosensible (23) et les seconds contacts conducteurs (24) et forme un motif fermé.

5. Procédé pour réduire le basculement d'une plaque transparente pendant la fabrication d'un capteur d'image de la revendication 1 dans lequel, dans le processus d'application d'adhésif (étape S30), l'adhésif (26) est appliqué à une zone entre une région photosensible (23) et les seconds contacts conducteurs (24) et forme un motif généralement en forme de C, le motif généralement en forme de C ayant un interstice (28).

6. Procédé pour réduire le basculement d'une plaque transparente pendant la fabrication d'un capteur d'image de la revendication 1 dans lequel, dans le processus d'application d'adhésif (étape S30), l'adhésif (26) est appliqué à une zone entre une région photosensible (23) et les seconds contacts conducteurs (24) et forme deux motifs en forme de L, les motifs en forme de L se faisant face de telle manière qu'un motif carré creux avec deux carrés opposés, chacun ayant un interstice (28), est formé.

7. Procédé pour réduire le basculement d'une plaque transparente pendant la fabrication d'un capteur d'image de la revendication 1 dans lequel une pluralité d'espaceurs à bille (27) est de plus ajoutée dans l'adhésif (26).

8. Procédé pour réduire le basculement d'une plaque transparente pendant la fabrication d'un capteur d'image de la revendication 1 dans lequel une température ambiante dans le processus d'application d'adhésif (étape S30) ou dans le processus de fermeture de plaque transparente (étape S40) est de l'ordre de 35°C à 45°C.

9. Procédé pour réduire le basculement d'une plaque transparente pendant la fabrication d'un capteur d'image de la revendication 1 dans lequel la plaque transparente est en verre ou dans lequel l'adhésif (26) est un adhésif photodurcissable.

10. Procédé pour réduire le basculement d'une plaque transparente pendant la fabrication d'un capteur d'image de la revendication 9 dans lequel l'adhésif photodurcissable est un adhésif durcissable aux ultraviolets (UV) et dans l'étape de fermeture de plaque transparente (étape S40), l'adhésif durcissable aux ultraviolets est durci par irradiation des rayons ultraviolets.

11. Procédé pour réduire le basculement d'une plaque transparente pendant la fabrication d'un capteur d'image de la revendication 1 dans lequel l'encapsulant (40) est appliqué pour couvrir des bords latéraux du produit semi-fini (200), l'adhésif (26) et la plaque transparente dans le processus d'emballage (étape S50) ou dans lequel l'encapsulant (40) est disposé sur le substrat de circuit (10) et couvre les bords latéraux de la puce de capteur d'image (20), l'adhésif (26) et la plaque transparente dans le processus d'emballage (étape S50).

12. Procédé pour réduire le basculement d'une plaque transparente pendant la fabrication d'un capteur d'image de l'une des revendications précédentes dans lequel la plaque transparente comprend une couche intermédiaire (32) et une plaque transparente (30), la couche intermédiaire (32) ayant une structure carrée creuse et une rainure en forme de cadre (33) formée sur un côté intérieur d'une surface supérieure (35) de la couche intermédiaire (32), la couche intermédiaire (32) étant alignée avec et fixée de manière adhésive à l'adhésif (26) dans le processus de montage de plaque transparente (étape S40), la plaque transparente (30) étant fixée de manière adhésive à la rainure en forme de cadre (33).

13. Procédé pour réduire le basculement d'une plaque transparente pendant la fabrication d'un capteur d'image de la revendication 12 dans lequel la couche intermédiaire (32) a un évidement (34) tel que, une fois que la plaque transparente (30) est fixée à la couche intermédiaire (32), un interstice (28') est formé à l'extérieur de la plaque transparente (30).

14. Procédé pour réduire le basculement d'une plaque transparente pendant la fabrication d'un capteur d'image de la revendication 12 dans lequel la couche intermédiaire (32) est en verre, en céramique, en un polymère à cristaux liquides, en un composé de moulage, en un polymère à base de siloxane, en un film photosensible sec ou en un masque de soudure.

15. Procédé selon la revendication 5, 6 ou 13 comprenant de plus une étape de scellement d'interstice (étape S45) dans laquelle l'interstice ou les interstices (28/28') sont scellés avec un produit de scellement après le processus de montage de plaque transparente (étape S40),
